# EUROPEAN PATENT APPLICATION

(11) **EP 4 617 123 A1**
(43) Date of publication of application: **17.09.2025**
(21) Application number: 22965105.4
(22) Date of filing: 09.11.2022
(51) Int. Cl.: B60R 16/02

(54) **COOLING STRUCTURE OF ON-BOARD ELECTRONIC UNIT**

(71) Applicant: Nissan Motor Co., Ltd., Kanagawa 220-8623 (JP)
(72) Inventor: OZAKI Michio, Atsugi-shi, Kanagawa 243-0123 (JP); OOKI Kazuhiro, Atsugi-shi, Kanagawa 243-0123 (JP)
(74) Representative: Hoefer & Partner Patentanwälte mbB
(86) International application number: PCT/JP2022/041631
(87) International publication number: WO 2024/100780

(57) **Abstract**

A cooling structure (1, 1A, 1B, 1C) mounted on a vehicle includes an assembly of an electronic unit (2) with a blower and a cover (3) arranged in an orientation in which one side surface in a thickness direction of the assembly is arranged along a surface of a vehicle body panel (P). A case (20) of the electronic unit (2) includes an opening (21) that opens in the thickness direction and an exhaust port (22) that opens in a first direction orthogonal to the thickness direction. The cover (3) is provided to face the opening (21), includes an intake port (33) that opens in a second direction orthogonal to the thickness direction and different from the first direction, and forms an intake flow path (34) communicating the intake port (33) with the opening (21) between the case (20) and the cover (3).

## Description

### TECHNICAL FIELD

The present invention relates to a cooling structure of an electronic unit mounted on a vehicle.

### BACKGROUND ART

Patent Literature 1 proposes an electronic unit box that houses an electronic unit for electrically controlling a vehicle, and includes a cooling structure of the electronic unit.

In the electronic unit box, an air layer is formed as a refrigerant flow path between a primary peripheral wall on an outer side and a secondary peripheral wall on an inner side, and the electronic unit is housed in the secondary peripheral wall. The electronic unit is cooled by air circulating in the air layer. In this electronic unit box, a width of the air layer is narrower on an exhaust side than on an intake side. Alternatively, the width of the air layer gradually narrows from the intake side to the exhaust side. With this configuration, the air circulating in the air layer is kept at a low temperature, and the temperature of the electronic unit is made uniform, thereby effectively cooling the electronic unit as a whole and preventing deformation of the electronic unit due to a temperature difference.

### CITATION LIST

### PATENT LITERATURE

Patent Literature 1: Japanese Unexamined Patent Application Publication No. 11-354960

### SUMMARY OF INVENTION

### PROBLEMS TO BE SOLVED BY INVENTION

In the electronic unit box, it is necessary to ensure a wide space including a space for intake and exhaust.

An object of the present invention is to provide a cooling structure of an electronic unit mounted on a vehicle that is capable of efficiently cooling the electronic unit even in a narrow space limited in a thickness direction.

### SOLUTION TO SOLVE PROBLEMS

A cooling structure of an electronic unit mounted on a vehicle in accordance with an embodiment of the present invention includes an assembly of the electronic unit and a cover arranged in an orientation in which one side surface in a thickness direction of the assembly is arranged along a surface of a vehicle body panel. The electronic unit includes an electronic component, a blower fan, and a case. The case includes an opening that opens in the thickness direction and an exhaust port that opens in a first direction orthogonal to the thickness direction. The cover is provided to face the opening, includes an intake port that opens in a second direction orthogonal to the thickness direction and different from the first direction, and forms an intake flow path communicating the intake port with the opening between the case and the cover.

### EFFECTS OF INVENTION

According to the configuration above, the electronic unit can be efficiently cooled even in a narrow space limited in a thickness direction.

### BRIEF DESCRIPTION OF DRAWINGS

[FIG. 1] FIG. 1 is a partial perspective view of a luggage room of a vehicle provided with a cooling structure according to a first embodiment of the present invention, viewed from a rear side of the vehicle.
[FIG. 2] FIG. 2 is a perspective view of the cooling structure including an electronic unit and a cover according to the first embodiment.
[FIG. 3] FIG. 3 is an exploded perspective view of FIG. 2.
[FIG. 4] FIG. 4 is a perspective view of the electronic unit in FIG. 2 with the cover removed.
[FIG. 5] FIG. 5 is a cross-sectional view of the cooling structure in FIG. 2, taken in a vertical plane through an opening of the cover of the electronic unit, and viewed from a front side of the vehicle.
[FIG. 6] FIG. 6 is a cross-sectional view of the cooling structure in FIG. 2, taken in a horizontal plane passing through an opening of the case of the electronic unit, and viewed from above the vehicle.
[FIG. 7] FIG. 7 is a cross-sectional view of the cooling structure in FIG. 2, taken in a vertical plane passing through a first wall of the cover, and viewed from a right side of the vehicle.
[FIG. 8] FIG. 8 is a cross-sectional view of the cooling structure in FIG. 1, taken in a vertical plane passing through a rear position of the vehicle relative to a bracket, and viewed from the rear side of the vehicle.
[FIG. 9] FIG. 9 is a cross-sectional view of the cooling structure in FIG. 1, taken in a vertical plane passing through an opening of the case of the electronic unit, and viewed from the rear side of the vehicle.
[FIG. 10A] FIG. 10A is a side view of the cooling structure of FIG. 2, viewed from the right side of the vehicle.
[FIG. 10B] FIG. 10B is a side view of the cooling structure according to another embodiment, viewed from the right side of the vehicle.
[FIG. 11] FIG. 11 is a partial perspective view of a luggage room of a vehicle provided with a cooling structure according to a second embodiment of the present invention, viewed from a rear side of the vehicle.
[FIG. 12A] FIG. 12A is a cross-sectional view of the cooling structure in FIG. 11, taken in a horizontal plane through an opening of a case of an electronic unit, and viewed from an upper side of the vehicle.
[FIG. 12B] FIG. 12B is a cross-sectional view at a section XIIB-XIIB in FIG. 12A.
[FIG. 13] FIG. 13 is a side view of the cooling structure including the electronic unit, a cover, and a duct according to the second embodiment, viewed from a right side of the vehicle.
[FIG. 14] FIG. 14 is a partial perspective view of a luggage room of a vehicle provided with a cooling structure according to a modification of the second embodiment, viewed from a rear side of the vehicle.

### DESCRIPTION OF EMBODIMENTS

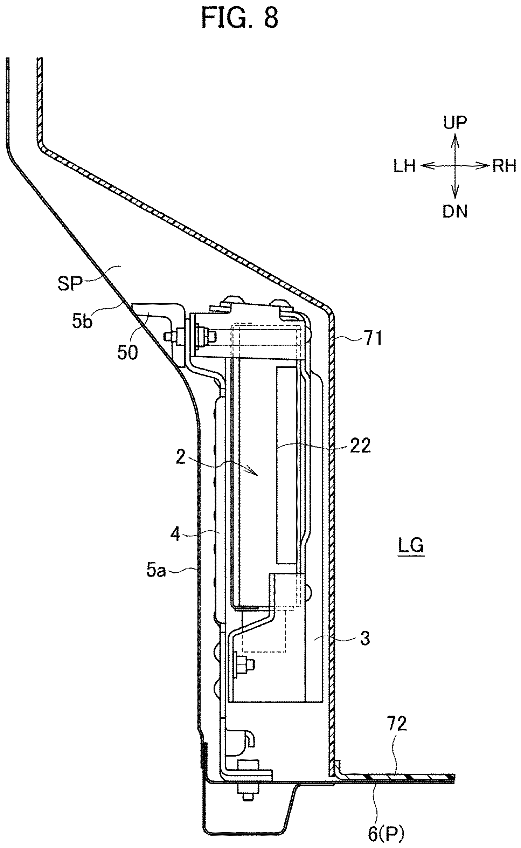

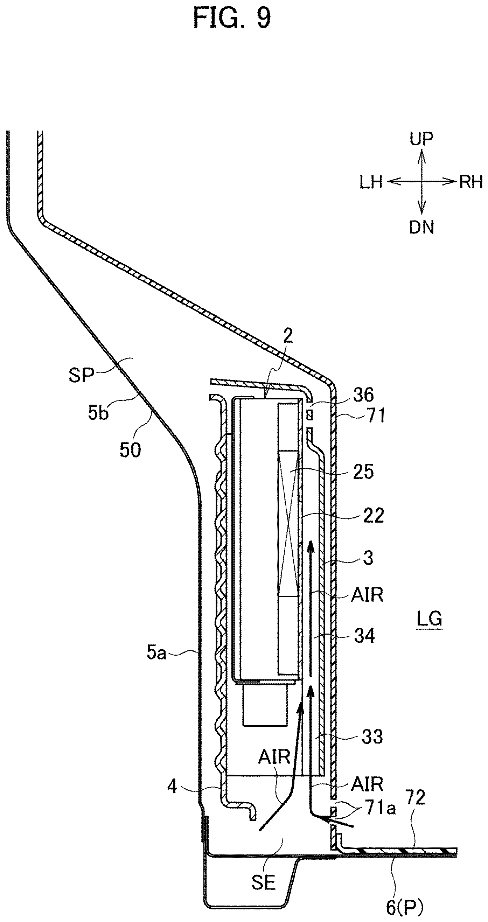

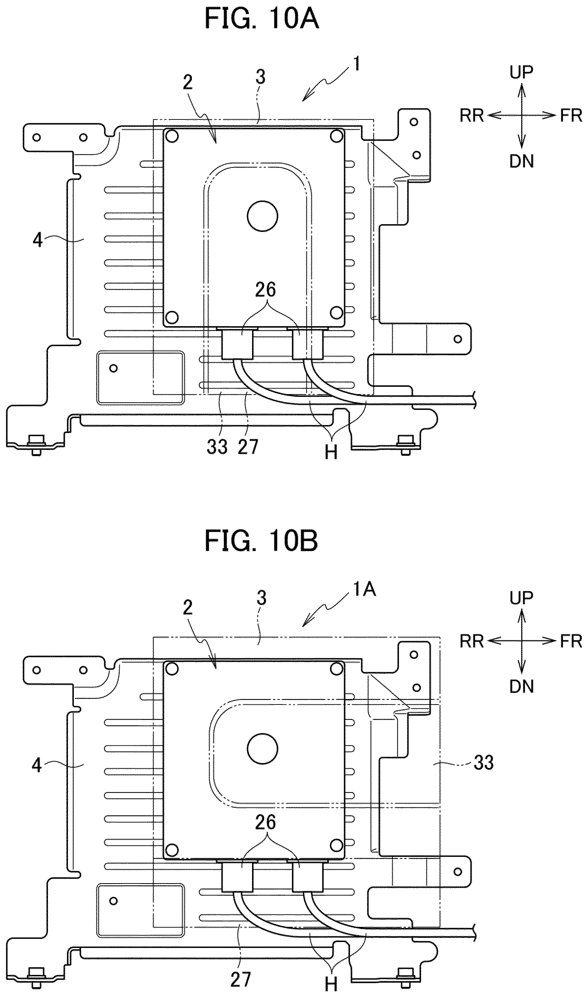

Embodiments of the present invention will be described in detail below with reference to the drawings. In the drawings, FR denotes a forward direction of a vehicle, RR denotes a rearward direction of the vehicle. RH denotes a rightward direction of the vehicle, and LH denotes a leftward direction of the vehicle. UP denotes an upward direction of the vehicle, and DN denotes a downward direction of the vehicle. In the following description, the terms "forward, rearward, rightward, leftward, upward, and downward directions" mean directions of the vehicle as described above unless otherwise specified. In the drawings other than FIGS. 8 and 9, a side trim 71 is not illustrated so that an electronic unit 2, a cover 3, or the like can be easily seen. In the drawings other than FIGS. 10A and 10B, a harness H is not illustrated.

### (First Embodiment)

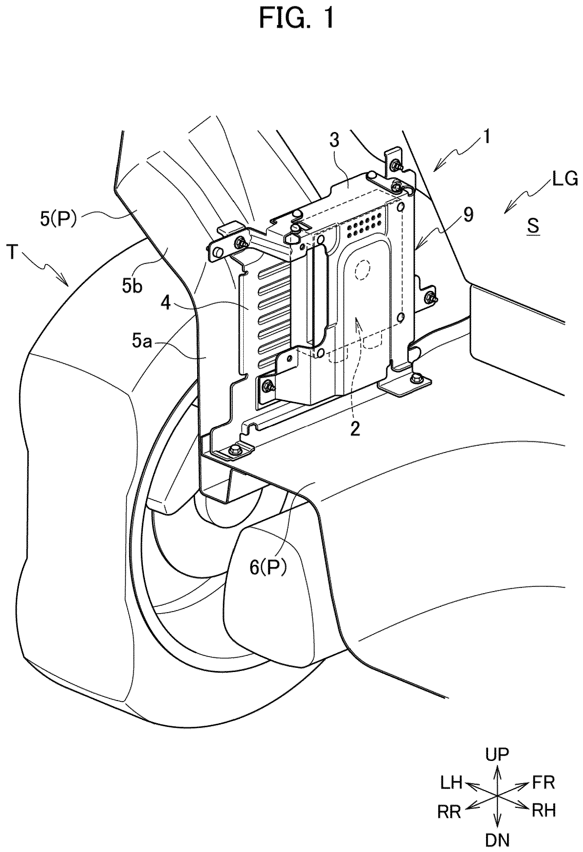

A cooling structure 1 of the electronic unit 2 mounted in a vehicle according to a first embodiment will be described with reference to FIGS. 1 to 10A. As illustrated in FIG. 1, the cooling structure 1 includes an assembly 9 of the electronic unit 2 and the cover 3, and is provided in a rear of a vehicle, more specifically, in a luggage room LG of the vehicle. The electronic unit 2 according to the present embodiment is a DC to AC inverter that converts DC power from a high-voltage battery mounted on a vehicle into AC power (100 V in Japan, 120 V in North America, and 220 V in Europe, China, and other areas) for use in consumer electronics. That is, heat loss occurs due to switching of the electronic unit 2. Therefore, the electronic unit 2 needs to be cooled.

The luggage room LG is a space formed rearward of a rear seat S. When the rear seat S is foldable, the luggage room LG also includes a space obtained by folding the rear seat S. As illustrated in FIGS. 1, 8, and 9, the luggage room LG includes a wheelhouse 5 of a rear wheel tire T on a left side, a floor panel 6, and the side trim 71, which is an interior trim arranged at the inner side of a vehicle interior than the wheelhouse 5 (closer to a center of a vehicle in a vehicle width direction). The wheelhouse 5 and the floor panel 6 are also called a vehicle body panel P.

The wheelhouse 5 is a part of a metal side panel of the vehicle, and houses the rear wheel tire T on a left side of the vehicle outside the vehicle interior. As illustrated in FIGS. 1, 8, and 9, the wheelhouse 5 includes an inner wall surface 5a as a surface inside the vehicle interior, extending in the forward-rearward and upward-downward directions, and an inclined surface 5b which integrally extends from an upper edge of the inner wall surface 5a toward an upper left side. A sub-bracket 50 for fixing a bracket 4 is welded to a lower part of the inclined surface 5b. The wheelhouse 5 is made of metal. However, the material is not particularly limited, and may be made of, for example, a resin or fiber-reinforced resin. In the present embodiment, the assembly 9 is mounted on the wheelhouse 5 at the left side, but may be mounted on the wheelhouse 5 at the right side. In this case, the structure of the cooling structure 1 according to the present embodiment may be reversed horizontally.

As illustrated in FIG. 1, the floor panel 6 is a metal plate having a surface extending in the forward-rearward and rightward-leftward directions, and forms a floor surface of the luggage room LG. An upper surface of the floor panel 6 is provided with a floor trim 72 which is an interior trim connected to a lower edge of the side trim 71. The left edge of the floor panel 6 is fixed to a lower part of the inner wall surface 5a of the wheelhouse 5 by bolts, welding, or the like. At a left end of the floor panel 6, two bolt holes are provided for fixing two extension portions 41 on a lower part of the bracket 4 with bolts BT and nuts NT, as described below. The floor panel 6 is made of metal. However, the material is not particularly limited, and may be made of, for example, a resin or fiber-reinforced resin.

The assembly 9 is fixed to the wheelhouse 5 and the floor panel 6 via the bracket 4. In the present embodiment, the assembly 9 is arranged not along the floor panel 6 but along the inner wall surface 5a of the wheelhouse 5 in order to improve a storage capacity of the luggage room LG.

As illustrated in FIGS. 8 and 9, the side trim 71 is a resin plate having a surface extending in the forward-rearward and upward-downward directions (a surface along the inner wall surface 5a of the wheelhouse 5), and a surface along the inclined surface 5b of the wheelhouse 5. A lower part of the side trim 71 extends to the floor panel 6, and an upper part of the side trim 71 extends to a ceiling of the vehicle. The side trim 71 is arranged in the inner side of the vehicle interior than the wheelhouse 5, the bracket 4, the electronic unit 2, and the cover 3. As illustrated in FIGS. 8 and 9, the bracket 4 and the assembly 9 are arranged in a space SP surrounded by the side trim 71, the wheelhouse 5, and the floor panel 6. That is, the side trim 71 is arranged on an opposite side of the assembly 9 to the wheelhouse 5 to cover the assembly 9. As illustrated in FIG. 9, the side trim 71 has a plurality of slit-like vent holes 71a in an intake area SE in the vicinity of an intake port 33 of the cover 3 described below. The plurality of slit-like vent holes 71a communicate a space at the side of the wheelhouse 5 with a space at the inner side in the vehicle interior. The side trim 71 is made of a resin or the like. However, the material is not particularly limited, and may be made of, for example, metal or a fiber-reinforced resin. Further, the shape and number of the vent holes 71a are not limited as described above. For example, the shape may be circular and the number may be one.

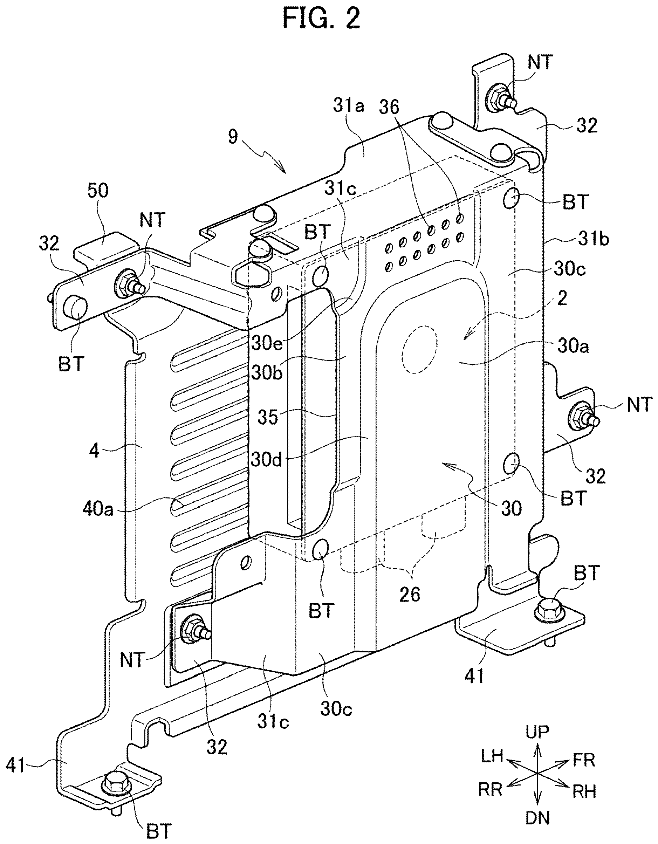

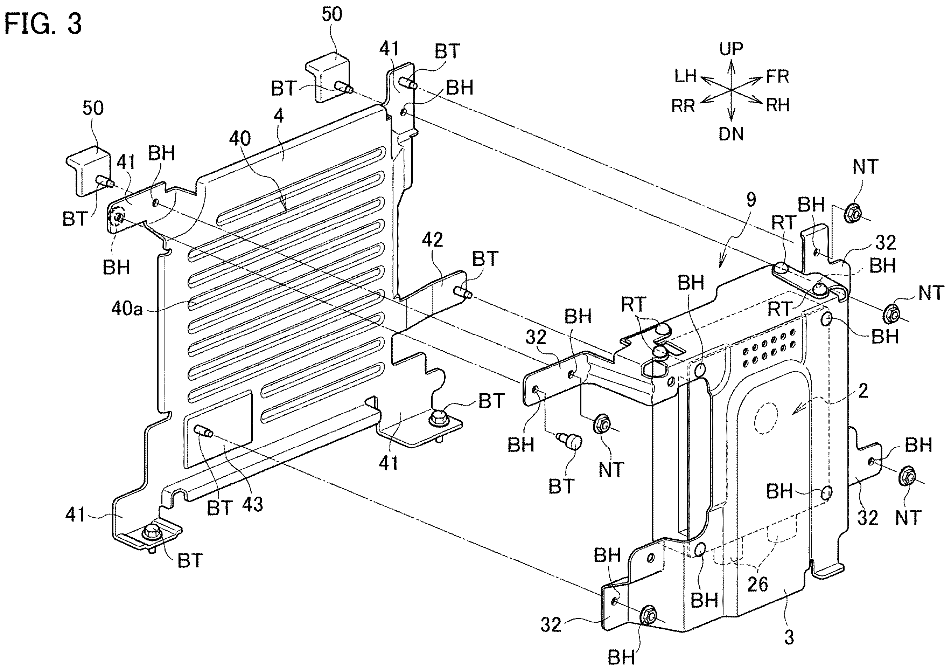

The bracket 4 is a member for fixing the assembly 9 to the luggage room LG, and is fixed to the wheelhouse 5 and the floor panel 6 (vehicle body panel P), as illustrated in FIG. 1. The bracket 4 is formed into a substantially flat plate by press-forming a high-tensile steel plate. As illustrated in FIGS. 2 and 3, the bracket 4 includes a central plate-like portion 40, extension portions 41 on a side, extension portions 41 on a lower side, a sub-extension portion 42, and a fixation portion 43. The central plate-like portion 40 has a surface extending in the forward-rearward and upward-downward directions. The extension portions 41 on an upper side integrally extend from upper right and left corners of the central plate-like portion 40. The extension portions 41 on the lower side integrally extend from lower right and left corners of the central plate-like portion 40 to the right. The sub-extension portion 42 integrally extends forward, from slightly below a center of a front edge of the central plate-like portion 40. The fixation portion 43 is located rearward of and below the central plate-like portion 40.

The central plate-like portion 40A includes a plurality of beads 40a extending in the forward-rearward direction. A flange is formed at a periphery of the central plate-like portion 40. The beads 40a and the flange contribute to improving strength and rigidity of the central plate-like portion 40. The extension portions 41 on the upper side are fixation portions for fixing the bracket 4 to the sub-bracket 50, and fixation portions for fixing the cover 3. The extension portions 41 on the lower side serve as fixation portions for fixing the bracket 4 to the floor panel 6. The sub-extended portion 42 serves as a fixation portion for fixing the bracket 4 to the inner wall surface 5a of the wheelhouse 5. The fixation portion 43 serves as a fixation portion for fixing the cover 3. Bolt holes for fixation are formed in each extension portion 41, sub-extension portion 42, and fixation portion 43. The bracket 4 is made of metal. However, the material is not particularly limited, and may be made of, for example, a resin or fiber-reinforced resin.

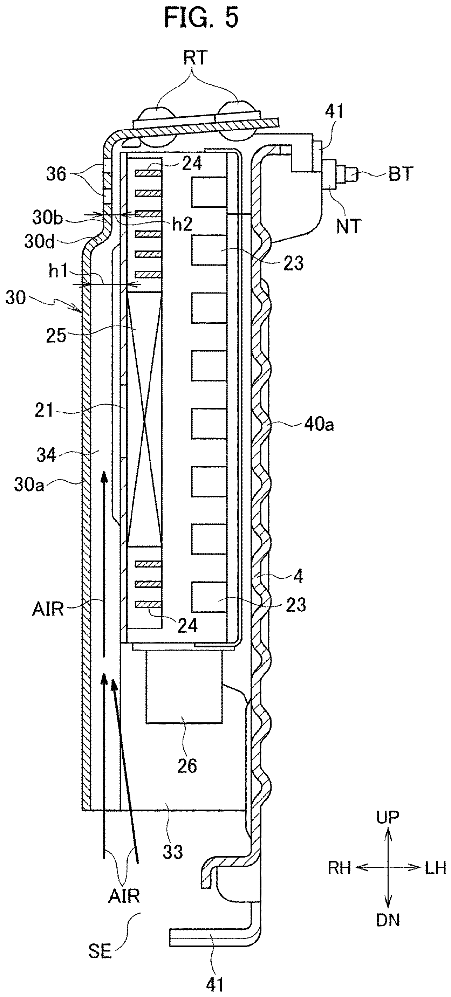

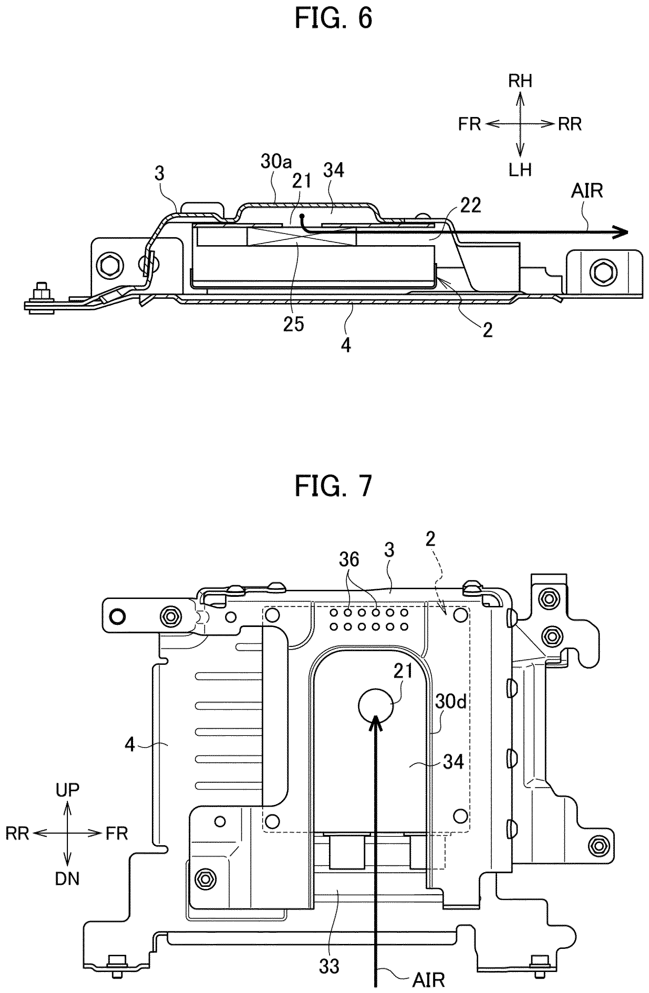

The electronic unit 2 is an inverter as described above. As illustrated in FIGS. 1 to 3, the electronic unit 2 is fixed to the cover 3, and to the bracket 4 via the cover 3. The electronic unit 2 includes a case 20, an electronic component 23, a cooling fin 24, a blower fan 25, and a harness terminal (harness connection) 26. The electronic component 23 and the cooling fin 24 are illustrated in FIG. 5, but not illustrated in FIGS. 6, 9, and 12A.

The electronic component 23 is driven by electricity supplied through the harness terminal 26, and generates heat. The cooling fin 24 takes in heat generated by the electronic component 23, and dissipates the heat into air. The blower fan 25 includes a fan, and a drive source for rotating the fan, such as a motor. The blower fan 25 cools the cooling fins 24 by generating air flow by rotation of the fan. The drive source is driven by electricity supplied through the harness terminal 26. The case 20 has a box shape, and houses therein the electronic components 23, the cooling fins 24, and the blower fan 25. The electronic unit 2 need not have the cooling fins 24, but may be configured to directly cool the electronic components 23 by air flow from the blower fan 25.

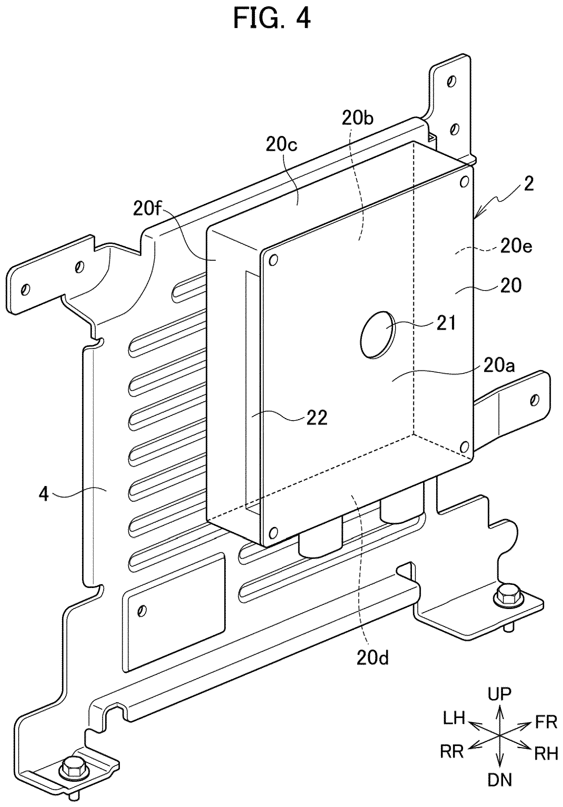

As illustrated in FIG. 4, the case 20 of the electronic unit 2 has a primary face 20a facing to the right, a reverse face 20b facing to the left, a top face 20c facing upward, a bottom face 20d facing downward, a front face 20e facing forward, and a rear face 20f facing rearward. The electronic unit 2 is arranged such that the primary face 20a of the case 20 is aligned with the side trim 71, and the reverse face 20b of the case 20 is aligned with the inner wall surface 5a of the wheelhouse 5. With the assembly 9 attached to the bracket 4, the reverse face 20b of the case 20 is separated from the central plate-like portion 40 of the bracket 4. A thickness direction generally means a direction orthogonal to an extension direction of a flat object. In the present embodiment, the thickness direction of the electronic unit 2 (case 20) is a direction orthogonal to the primary face 20a and the reverse face 20b of the case 20. The thickness direction of the electronic unit 2 coincides with the thickness direction of the assembly 9. The case 20 does not have to be a strictly rectangular parallelepiped shape, but may have a shape with mutually orthogonal or substantially orthogonal surfaces in which an opening 21 and an exhaust port 22 described below can be provided.

As illustrated in FIGS. 4 and 7, the opening 21 that opens to the right is provided substantially in a center of the primary face 20a of the case 20. That is, the opening 21 is provided on the primary face 20a of the case 20, which is a surface opposite to the wheelhouse 5 and the bracket 4. The opening 21 serves as an opening for taking in air (taking in air for cooling) from the outside of the case 20 into the inside of the case 20 by the blower fan 25. Bolt holes for fixing the cover 3 are provided at four corners of the primary face 20a of the case 20. In the present embodiment, the shape of the opening 21 is circular, and the position of the opening 21 is substantially centered. However, without limitation, any shape and position of the opening can be adopted.

The rear face 20f of the case 20 is provided with the exhaust port 22 which opens rearward, more specifically rearward of the wheelhouse 5. The exhaust port 22 serves as an opening for exhausting air, which is taken into the case 20 from the opening 21 by the blower fan 25, to the outside of the case 20. In this embodiment, the shape of the exhaust port 22 is rectangular. However, without limitation, the exhaust port can take any shape.

On the bottom face 20d of the case 20, two harness terminals 26 project downward to form harness connections. As illustrated in FIG. 10A, harnesses H extending from an on-board high-voltage battery are connected to the harness terminals 26.

The cover 3 is formed by press-forming a high-tension steel plate. The cover 3 is formed in a box-like shape by fixing the press-formed steel plate with rivets RT at several locations. An electronic unit 2 is attached to the cover 3. As illustrated in FIGS. 1, 8, and 9, the cover 3 is fixed to the bracket 4 at the inner side of the vehicle interior than the wheelhouse 5, with the electronic unit 2 being attached. Thus, the electronic unit 2 is housed in a space formed by the cover 3 and the bracket 4.

As illustrated in FIG. 2, the cover 3 includes a body 30 having a surface extending in the forward-rearward and upward-downward directions and facing the primary face 20a of the case 20. A lower end of the body 30 is located below a lower end of the case 20 and above a lower end of the bracket 4. The body 30 includes a first face 30a, a second face 30b located leftward (toward the case 20) of the first face 30a, and a third face 30c located leftward of the second face 30b. The body 30 includes a first wall 30d connecting the first face 30a with the second face 30b and the third face 30c, and a second wall 30e connecting the second face 30b and the third face 30c.

The first face 30a is a surface larger than the opening 21 of the case 20, and faces the opening 21 to entirely cover the opening 21. The first face 30a extends downward from an upper vicinity of the opening 21 to a lower end of the primary face 20a of the case 20. The first wall 30d is provided integrally with the first face 30a to surround a periphery of the first face 30a on three sides, that is, the rear, upper, and front sides, and extends to the left from the first face 30a. The lower portions of the first face 30a and the first wall 30d open downward to form an intake port 33 for taking in air from the outside of the case 20 and the cover 3. The first face 30a and the first wall 30d form, together with the primary face 20a of the case 20, an intake flow path 34 that allows communication between the intake port 33 and the opening 21. The opening 21 of the electronic unit 2 is located in the intake flow path 34.

As illustrated in FIG. 9, the intake port 33 opens into the space SP formed by the wheelhouse 5, the floor panel 6, and the side trim 71. The vicinity of the intake port 33 forms an intake area SE for taking in air used for cooling electronic components.

As illustrated in FIGS. 2 and 7, the second face 30b includes a plurality of through holes 36 above the opening 21 and the first face 30a, that is, in a portion of the cover 3, which faces an upper end face of the case 20 and in which the intake flow path 34 is not provided. The plurality of through holes 36 allow air to flow between a space between the case 20 and the cover 3, and an external space. For example, hot air contained in the space between the case 20 and the cover 3 is exhausted to the external space through the plurality of through holes 36. Depending on the condition, air flows into the space between the case 20 and the cover 3 through a plurality of through holes 36 from the outside. In this case, incoming air is taken in from the opening 21 and exhausted from the exhaust port 22. Note that the shape and number of the through holes 36 are not limited to those described above. For example, the shape may be a slit-like form, and the number of the through holes may be one. It is possible to prevent foreign matter, such as moisture, from entering the interior of the assembly 9 through the through holes 36, by providing the through holes 36 that open in the rightward-leftward direction instead of the upward-downward direction.

Bolt holes BH for fixing the case 20 to the cover 3 are provided on the third face 30c at positions corresponding to the bolt holes BH of the case 20.

As illustrated in FIG. 2, the cover 3 includes a top face portion 31a integrally extending to the left from an upper edge of the second face 30b and the third face 30c, a front face portion 31b integrally extending to the left from the front edge of the third face 30c, and a rear face portion 31c integrally extending to the from a rear edge of the third face 30c. A bottom face of the cover 3 opens downward, and serves as the intake port 33, as described above. The cover 3 further includes extension portions 32. One of the extension portions 32 integrally extends upward from an upper edge of the front face portion 31b, and another one of the extension portions 32 integrally extends forward from a lower edge of the front face portion 31b. Further, one of the extension portions 32 of the cover integrally extends rearward from a rear edge of the top face portion 31a, and another one of the extension portions 32 integrally extends rearward from a lower edge of the rear face portion 31c. Each extension portion 32 of the cover 3 includes a bolt hole BH for fixing the cover 3 to the bracket 4.

The top face portion 31a of the cover 3 covers the top face 20c of the case 20. The front face portion 31b of the cover 3 covers the front face 20e of the case 20, and extends below the lower end of the case 20. A lower end of the front face portion 31b is located above the lower end of the bracket 4. The rear face portion 31c of the cover 3 covers the rear face 20f of the case 20 from a position below the exhaust port 22 of the rear face 20f of the case 20, and extends below the lower end of the case 20. A lower end of the rear face portion 31c is located above the lower end of the bracket 4. The cover 3 includes a rear opening 35 for exposing the exhaust port 22 above the rear face portion 31c.

As illustrated in FIGS. 5 to 7, three end faces, that is, upper, front, and rear end faces of the primary face 20a of the case 20, which are located on three sides of the opening 21 and which are not provided with the intake flow path 34, block or inhibit air flow between the intake flow path 34 and the external space to a certain extent at the second face 30b and the third face 30c of the cover 3. However, since air is taken in by the blower fan 25, the three end faces of the primary face 20a of the case 20 and the cover 3 do not have to be completely sealed, and some air leakage is permitted. In other words, the air is taken into the intake flow path 34 mainly through the intake port 33. It should be noted that positions at which air flow between the intake flow path 34 and the external space is blocked or inhibited to a certain extent may be two end faces, or one end face of, the primary face 20a of the case 20.

More specifically, as illustrated in FIG. 5, a part of the primary face 20a of the case 20 with the opening 21 is provided with the intake flow path 34, and the part and the first face 30a of the cover 3 are separated by a separation distance (first separation distance) h1 in the rightward-leftward direction (vehicle width direction, thickness direction). Furthermore, an end face of the primary face 20a of the case 20 with the opening 21 is not provided with the intake flow path 34, and the end face and the second face 30b of the cover 3 are separated by a separation distance (second separation distance) h2 in the rightward-leftward direction. The separation distance (first separation distance) h1 is greater than the separation distance (second separation distance) h2. The separation distance (second separation distance) between the primary face 20a of the case 20 and the third face 30c of the cover 3, at which the case 20 and the cover 3 are attached to each other, in the rightward-leftward direction is 0. As illustrated in FIG. 7, a width of the intake flow path 34 in the forward-rearward direction is greater than or equal to the width of the opening 21 in the forward-rearward direction. Furthermore, a cross-sectional area of the exhaust port 22 illustrated in FIG. 8 is greater than or equal to a cross-sectional area of the intake flow path. In this embodiment, the cross-sectional shape of the intake flow path is rectangular, but is not limited to this, and any shape can be adopted. The effective cross-sectional area of the exhaust port 22 may be greater than or equal to the effective cross-sectional area of the intake flow path.

As illustrated in FIG. 10A, the intake port 33 of the cover 3 opens in the same direction as a harness connection port 27 that opens downward, and is accessible to the harness terminals 26. By opening the intake port 33 downward, a position of the intake port 33 can coincide with a position of the harness connection port 27. Here, for example, in the cooling structure 1A according to another embodiment (hereinafter referred to as a comparative embodiment) illustrated in FIG. 10B, the intake port 33 is provided to open forward, which is a direction different from an opening direction of the harness connection port 27. As a result, the position of the intake port 33 does not coincide with the position of the harness connection port 27. In the cooling structure 1A, the area required for the layout of the assembly 9 is increased by the intake port 33 or the harness connection port 27 compared to the cooling structure 1 according to the first embodiment. Thus, the cooling structure 1 according to the first embodiment can reduce the area required for the layout of the assembly 9 compared to the cooling structure 1A according to the comparative embodiment.

As illustrated in FIGS. 1, 8, and 9, in the assembly 9, the reverse face 20b of the electronic unit 2 is arranged along the inner wall surface 5a of the wheelhouse 5, and the body 30 of the cover 3 is arranged along the side trim 71. The assembly 9 is arranged in a narrow space between the wheelhouse 5 and the side trim 71.

Next, airflow in the cooling structure 1 according to the first embodiment while cooling will be described with reference to FIGS. 5, 7, and 9. First, as indicated by an arrow AIR in FIG. 6, an airflow from the opening 21 of the case 20 toward the exhaust port 22 is generated by driving a blower fan. Next, as indicated by the arrows AIR in FIGS. 5, 7, and 9, air in the intake area SE between the wheelhouse 5 located below the assembly 9, the floor panel 6, and the side trim 71 is taken in to flow upward from the intake port 33 of the cover 3, and is then taken into the intake flow path 34. At the same time, when air in the intake area SE is taken in from the intake port 33, air at the inner side of the vehicle interior of the vehicle flows into the intake area through vent holes 71a of the side trim 71, as illustrated in FIG. 9. Air taken into the intake flow path 34 is directed to the cooling fin 24 through the opening 21, and heated air is exhausted from the exhaust port 22. The heated air exhausted from the exhaust port 22 then flows into a space at a rear part of the vehicle between the side trim 71 and a part rearward of the wheelhouse 5 and is exhausted, as illustrated in FIG. 6. The space at the rear part of the vehicle is large, and there is nothing to block the flow, so that the heated air is exhausted and flows rearward and is then efficiently diffused in the space at the rear part of the vehicle, thereby dissipating heat. Further, spaces rearward, upward, and forward of the wheelhouse 5 communicate with each other, so that the heated air exhausted is also diffused to the spaces upward and forward of the wheelhouse 5. Therefore, the heated air exhausted from the exhaust port 22 is not easily taken in from the intake port 33. Moreover, the heat of the air exhausted from the exhaust port 22 is difficult to be transmitted to the air in the intake area SE.

An assembling procedure of the electronic unit 2, the cover 3, and the bracket 4 of the cooling structure 1 according to the first embodiment, and an attachment procedure to the vehicle body panel P will be described.

First, as illustrated in FIGS. 1 to 3, and 8, the bracket 4 is arranged in the luggage room LG of the vehicle; and the two extension portions 41 on the lower part of the bracket 4, and the left end of the floor panel 6 provided with the two bolt holes, are fixed by fastening the bolts BT and the nuts NT inserted into the bolt holes BH. With the bracket 4 fixed to the floor panel 6, the two extended portions 41 on the upper part of the bracket 4 are aligned with the sub-brackets 50.

Next, the electronic unit 2 is fixed to the cover 3. Specifically, the bolts BT are inserted into the bolt holes BH of the cover 3, and screwed into the bolt holes BH of the case 20, while the positions of the bolt holes BH provided at the four corners on the primary face 20a of the case 20 of the electronic unit 2, and the bolt holes BH provided at the third face 30c of the cover 3, are aligned. The electronic unit 2 and the cover 3 attached to each other constitutes the assembly 9.

Finally, as illustrated in FIG. 3, the cover 3 fixing the electronic unit 2 is attached to the bracket 4. Specifically, by fastening the bolts BT and the nuts NT inserted into the bolt holes BH, the extension portions 42 of the cover 3 are fixed to the extension portions 41, the sub-extension portion 42, and the fixation portion 43 of the bracket 4 which are corresponding to the extension portions 32. Thus, the electronic unit 2, the cover 3, and the bracket 4 of the cooling structure 1 are assembled and attached to the vehicle body panel P.

As described above, in the first embodiment, the assembly 9 is attached to the wheelhouse 5 and the floor panel 6 in an orientation in which one side surface in the thickness direction is arranged along the inner wall surface 5a of the wheelhouse 5 which is a side panel of the vehicle. It should be noted that the fixation method is not limited to those described above. For example, the number and position of bolts BT, nuts NT, and bolt holes BH are not limited to those described above. Furthermore, instead of the fastening/fixation method by bolts BT, nuts NT, and bolt holes BH, a fixation method by welding, adhesion, screws, fitting, or the like, may be adopted. The shape, position, number, or the like of the fixation portions for fixing the members are not limited to those described above. Moreover, the order of fixing the members is not limited to that described above.

Operation and effect according to the first embodiment will be described below:
(1) The assembly 9 having the electronic unit 2 and the cover 3 is arranged in such a manner that a surface in the thickness direction is aligned with the inner wall surface 5a of the wheelhouse 5, which is a vehicle body panel. Further, the intake port 33 opens downward, and the intake flow path 34 is provided in the rightward-leftward direction (vehicle width direction). An exhaust flow path is not provided in the rightward-leftward direction, but the exhaust port 22 opening rearward is provided. Therefore, the space existing in an exhaust direction of the exhaust port 22 can be effectively utilized as an exhaust flow path. It is not necessary to provide the exhaust flow path in the thickness direction of the electronic unit 2, so that the size of the assembly 9 in the thickness direction can be suppressed. Therefore, the assembly 9 can be arranged in a narrow space in which a space in the thickness direction and a space for an intake port are limited. The intake port 33 and the exhaust port 22 open in different directions, viewed in the thickness direction. Therefore, the heated air exhausted from the exhaust port 22 flows and diffuses in a direction away from an installation position of the intake port 33. As a result, the heated air exhausted from the exhaust port 22 is not easily taken in again from the intake port 33. Thus, even in a narrow space limited in the thickness direction, the electronic unit 2 can be efficiently cooled.
(2) When a space in a vehicle is regarded as a flow path, a flow path cross-sectional area (or effective cross-sectional area) of the space in the vehicle, to which the heated air exhausted from the exhaust port 22 is exhausted, is greater than a flow path cross-sectional area (or effective cross-sectional area) of the intake flow path 34. Therefore, pressure loss is not easily generated in the air flow until the air taken in from the intake port 33 is exhausted to the space of the vehicle through the intake flow path 34 and the exhaust port 22. As a result, it is not necessary to increase the output of the blower fan 25. Therefore, the electronic unit 2 requiring cooling can be arranged in a limited space (for example, the vehicle's luggage room LG) with good space efficiency, and the duct can be routed as necessary. Moreover, the flow path cross-sectional area (or effective cross-sectional area) of the space in the vehicle, to which the air is exhausted, is greater than the flow path cross-sectional area (or effective cross-sectional area) of the intake flow path 34, so that it is not necessary to seal the intake flow path 34. Therefore, a structure for sealing the intake flow path 34 is unnecessary, and it is possible to suppress an increase in the manufacturing cost of members and an increase in the cost and weight due to an increase in the number of parts.
(3) The air is not efficiently taken in if the opening 21 is placed too close to other members, such as the side trim 71 when arranging the electronic unit 2 in the vehicle. In the first embodiment, the cover 3 is provided at a position facing the opening 21 of the electronic unit 2. Therefore, the distance between the opening 21 and other members can be ensured, and the air intake can be efficiently performed. Further, the cover 3 in the electronic unit 2 can provide a function of protecting the electronic unit 2, either alone or together with the bracket 4, against interference in a rear collision, or the like.
(4) A part of the primary face 20a having the opening 21 of the case 20 is provided with the intake flow path 34, and the distance h1 between the part and the cover 3 is greater than the distance h2 between the end face that is not provided with the intake flow path 34, and the cover 3, in the thickness direction. Therefore, the pressure loss is small, and the air flows easily to the opening 21. Further, the intake flow path 34 can be easily provided without providing a seal component on the end face of the case 20. It should be noted that the intake flow path 34 takes in air from the blower fan 25, and a small amount of air leakage is permitted, unlike the flow path which requires waterproofing. Furthermore, by closing the space on the exhaust port 22 side (reducing the distance between the case 20 and the cover 3), the heated air exhausted from the exhaust port 22 cannot be easily taken in through the opening 21. In addition, end faces of the primary face 20a having the opening 21 of the case 20, which are not provided with the intake flow path 34, are three end faces located on three sides of the opening 21. Therefore, the heated air exhausted from the three end faces is not easily taken into the intake flow path 34.
(5) The assembly 9 is installed on the side panel (more specifically, wheelhouse 5) of the luggage room LG of the vehicle. The exhaust port 22 opens in the rearward direction of the vehicle, and the intake port 33 opens in the downward direction of the vehicle. Therefore, a space SP between the side panel of the luggage room LG and the side trim 71 allows in particular rearward, upward, and forward communication in the vehicle, so that a sufficient space for diffusing the heated air exhausted from the exhaust port 22 can be ensured. In addition, the electronic unit 2 is vertically arranged between the side panel of the luggage room LG and the side trim 71, thereby improving the capacity of the luggage room LG. Furthermore, the electronic unit 2 is an inverter providing a household power source, and can be easily accessed by a user by arranging the electronic unit 2 in the luggage room LG.
(6) A plurality of circular through-holes 36 are provided above the opening 21 of the case 20 of the cover 3. Therefore, the hot air trapped between the case 20 and the cover 3 is easily exhausted to the outside through the plurality of through-holes 36 provided above the cover 3. Depending on the condition, air flows into the space between the case 20 and the cover 3 through the plurality of through-holes 36 from the outside, but in this case, the air that flows into the space is taken in through the opening 21 and exhausted from the exhaust port 22. Therefore, even in this case, the hot air trapped between the case 20 and the cover 3 is easily exhausted to the outside.
(7) The assembly 9 is installed on the side panel (more specifically, the wheelhouse 5) of the luggage room LG of the vehicle, and the intake port 33 opens downward. In addition, the harness connection port 27 is provided, through which the harness connection terminal (harness connection) 26 provided below the case 20 is accessible, and opens in the same direction as the intake port 33. Therefore, compared with the intake port 33 and the harness connection port 27 facing in different directions (Comparative Embodiment), the area required for the layout of the assembly 9 can be reduced. In addition, the harness connection can be protected against interference in a rear collision, or the like.
(8) The side trim 71 is provided to cover the assembly 9 on a side opposite to the side panel (more specifically, wheelhouse 5) of the assembly 9. The vent holes 71a are provided in the vicinity of the intake port 33 of the side trim 71. Therefore, when the electronic unit 2 is covered by the side trim 71, heat tends to accumulate in the space, but unheated air in the vehicle interior can be easily taken into the intake area SE through the vent holes 71a, and the temperature of the air taken in from the intake port 33 can be lowered. In particular, when the side trim 71 is made of a resin material, the heat accumulation may become noticeable, and therefore, it is more effective to provide the vent holes 71a in the side trim 71. Moreover, the intake flow path 34 is provided on the side trim 71 side of the assembly 9 in the thickness direction. Therefore, the intake port 33 can be arranged in the vicinity of the vent holes 71a of the side trim 71, and unheated air in the vehicle interior can be easily taken into the intake area SE through the vent holes 71a.
(9) The assembly 9 is installed in the wheelhouse 5 of the luggage room LG of the vehicle. Particularly, a space SP between the wheelhouse 5 of the luggage room LG and the side trim 71 widely communicates rearward, upward, and forward direction of the vehicle. Therefore, heated air exhausted from the exhaust port 22 diffuses rearward, upward, and forward direction of the wheelhouse 5. Therefore, sufficient space for diffusing heated air exhausted from the exhaust port 22 can be ensured.
(10) With the assembly 9 attached to the bracket 4, the reverse face 20b of the case 20 is separated from the central plate-like portion 40 of the bracket 4. Therefore, heat radiation from the reverse face 20b of the case 20 can be enhanced.

### (Second Embodiment)

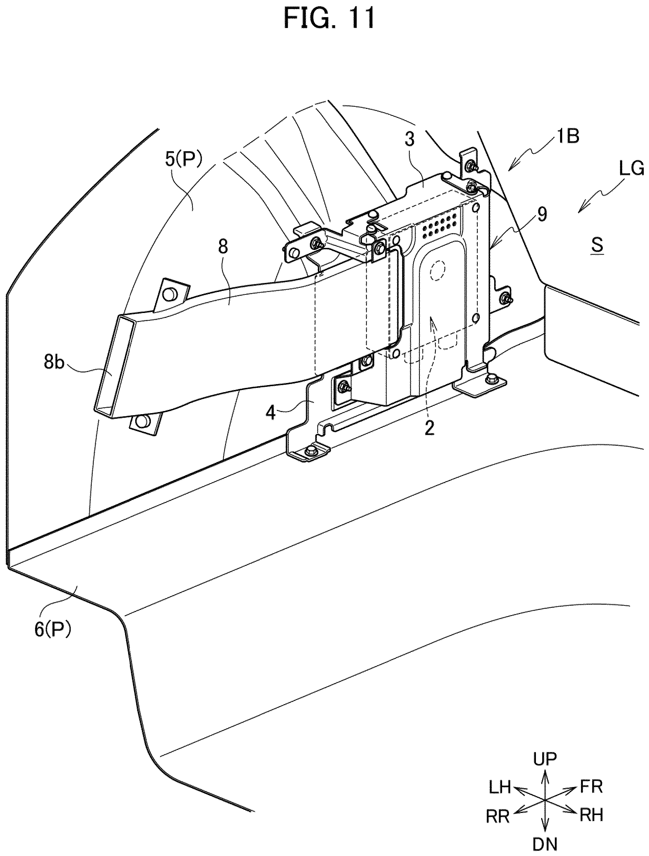

A cooling structure 1B of the electronic unit 2 mounted in the vehicle according to a second embodiment will be described with reference to FIGS. 11 to 13. Since the second embodiment has the same configuration as the first embodiment described above except that a duct 8 described below is provided, the parts of the same configuration are denoted by the same reference signs, and the description will be omitted.

As illustrated in FIG. 11, the cooling structure 1B includes the duct 8, which is made of resin, extending from the exhaust port 22 of the case 20 of the electronic unit 2 in the rearward direction of the vehicle. The duct 8 has a tubular shape in which a duct connection port 8a located at one end communicates with a duct exhaust port 8b located at the other end. The duct connection port 8a is connected to the exhaust port 22 in the vicinity of the rear opening 35 of the cover 3. The duct exhaust port 8b opens into a space rearward of the wheelhouse 5 between the side trim 71 and a portion rearward of the wheelhouse 5. The rear space is located rearward of a rear end of the wheelhouse 5 separated rearward from the exhaust port 22.

The duct 8 exhausts air exhausted from the exhaust port 22 through the duct connection port 8a to the space rearward of the wheelhouse 5 through the duct flow path (exhaust flow path), which is a space in the tube.

The shape of the duct 8 is not limited to a tubular shape as long as the air exhausted from the exhaust port 22 can be exhausted to a separated space. The duct 8 is made of resin. However, the material is not particularly limited, and may be made of, for example, metal or fiber-reinforced resin. The connection between the duct connection port 8a and the exhaust port 22 may be completely or partially sealed as long as most of the exhaust from the exhaust port 22 can be introduced into the tube. For example, a sealing member, such as a resin packing, may be arranged between the duct connection port 8a and the exhaust port 22 to enhance the sealing between the duct connection port 8a and the exhaust port 22.

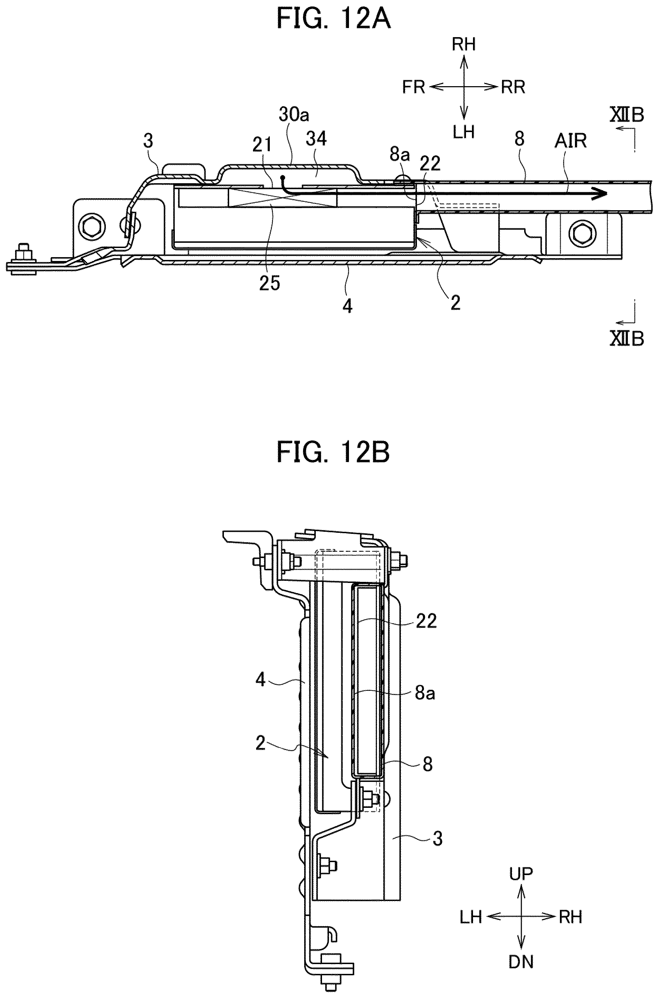

A cross-sectional area (or effective cross-sectional area) of a duct flow path inside the duct 8 illustrated in FIG. 12B is greater than a cross-sectional area (or effective cross-sectional area) of the exhaust port 22 illustrated in FIG. 8 and a cross-sectional area (or effective cross-sectional area) of the intake flow path 34 illustrated in FIG. 6. A flow path cross-sectional area (or effective cross-sectional area) of the duct flow path may be less than a flow path cross-sectional area (or effective cross-sectional area) of the exhaust port 22.

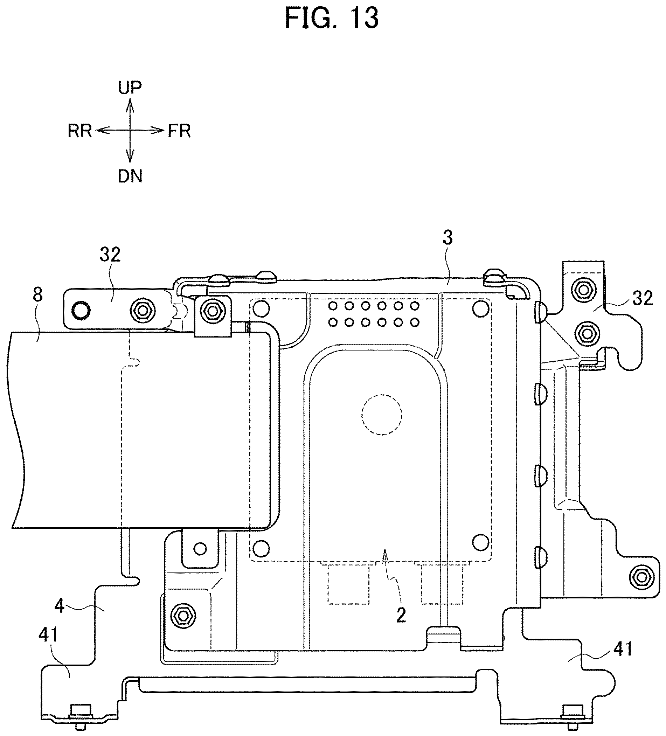

As illustrated in FIG. 13 viewing from the right, the duct 8 is connected to the exhaust port 22 at the rear side of the assembly 9, and extends rearward. When viewed from the right, the rear end of the case 20 is located forward of the duct 8 and a rear end of the bracket 4.

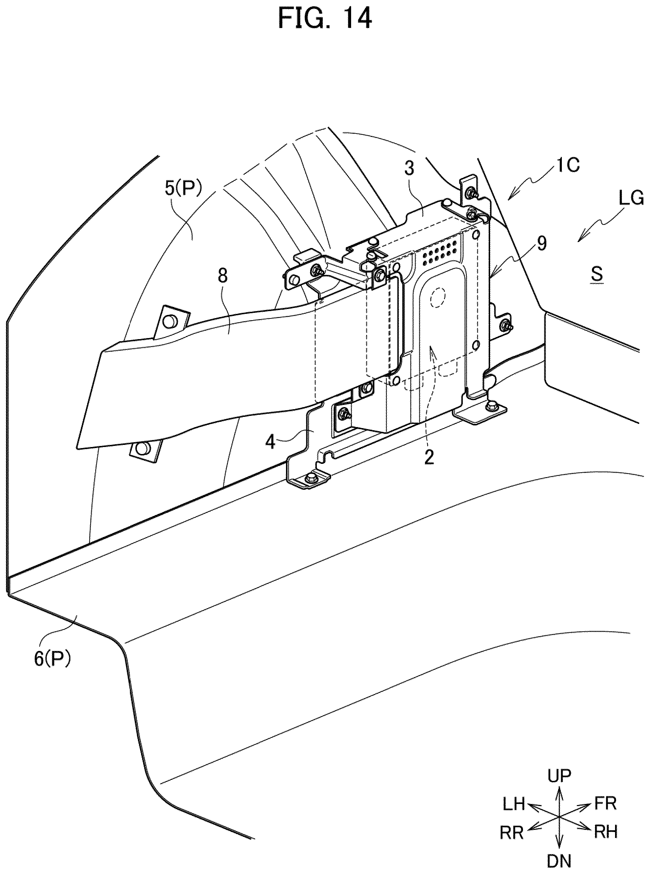

In the second embodiment, a space into which the duct exhaust port 8b opens is not limited to the space rearward of the wheelhouse 5 between the side trim 71 and the portion rearward of the wheelhouse 5. As an example, a cooling structure 1C according to a modification of the second embodiment will be described. As illustrated in FIG. 14, in the cooling structure 1C, the duct exhaust port 8b opens in a space communicating with a drafter (not illustrated) of the vehicle for exhausting the intake air by the air conditioner, or the like, to the outside of the vehicle, through a hole penetrating the vehicle body panel P rearward of the wheelhouse 5.

Operation and effect obtained according to the second embodiment and the modification of the second embodiment will be described below. The second embodiment and the modified example of the second embodiment have the same configuration as that of the first embodiment except that the air outlet (exhaust port 22) in the first embodiment is changed to the duct exhaust port 8b of the duct 8. Therefore, the effects (1) to (10) of the first embodiment described above can also be achieved in the second embodiment and the modified example of the second embodiment.
(1) In the second embodiment and the modified example of the second embodiment, the duct 8 connected to the exhaust port 22 of the case 20 is provided. Therefore, the air exhausted from the exhaust port 22 can be exhausted to a space further away from the intake port 33 by the duct 8, and the heated air exhausted from the exhaust port 22 can be prevented from being taken in again from the intake port 33. Moreover, a flow path cross-sectional area (or effective cross-sectional area) of the duct 8 is greater than a flow path cross-sectional area (or effective cross-sectional area) of the intake flow path 34. Therefore, the pressure loss is small, and the exhaust from the intake port 33 to the duct exhaust port 8b can be further enhanced. Moreover, it is not necessary to increase the output of the blower fan 25, and to seal the intake flow path 34.
(2) In the second embodiment, the assembly 9 is installed on the body panel (more specifically, wheelhouse 5) of the luggage room LG of the vehicle, and the opening direction of the exhaust port 22 is set to the rearward direction of the vehicle. The duct 8 extends to the space rearward of the wheelhouse 5. Therefore, the air exhausted from the exhaust port 22 can be exhausted to a relatively large rear space of the vehicle body panel of the luggage room LG away from the exhaust port 22, and the heated air exhausted from the exhaust port 22 can be efficiently diffused.
(3) In the second embodiment and the modified example of the second embodiment, the opening direction of the exhaust port 22 is set to the rearward direction of the vehicle, and the duct 8 extends rearward. The assembly 9 is attached to the vehicle body panel P via the bracket 4, and the rear end of the case 20 of the electronic unit 2 is located forward of the rear end of the bracket 4. Hence, the electronic unit 2 is arranged at least forward of the bracket 4, although an interfering object may hit the electronic unit 2 from behind in a rear collision. Therefore, interference of the interfering object with the electronic unit 2 can be suppressed by the bracket 4, and short-circuit of the energized portion of the electronic unit 2 can be reduced. Moreover, even if an interfering object interferes with the electronic unit 2, the interference occurs through the duct 8 instead of the electronic component 23. As a result, short-circuiting of an energized portion of the electronic unit 2 can be reduced.
(4) In the modified example of the second embodiment, the duct exhaust port 8b opens in a space communicating with the drafter through a hole penetrating the vehicle body panel. Therefore, heated air exhausted from the duct exhaust port 8b is exhausted into a space with a negative pressure generated by the drafter. As a result, heated air exhausted from the duct exhaust port 8b can be more reliably prevented from being taken in again from the intake port 33.

### (Other Embodiments)

The first embodiment, the comparative embodiment, the second embodiment, and a modification of the second embodiment of the present invention are described above. However, configurations described below can be adopted in these embodiments.

In all of the embodiments described above, the cooling structures 1 to 1C includes the assembly 9 of the electronic unit 2 and the cover 3, but may additionally include at least one of the bracket 4, the wheelhouse 5, the floor panel 6, and the side trim 71.

In all of the embodiments described above, the cover is provided with a plurality of the through holes 36, but the through holes 36 need not be provided.

In all of the embodiments described above, the side trim 71 is provided with the vent holes 71a, but the vent holes 71a need not be provided. Even when the side trim 71 does not have the vent holes 71a, the air exhausted from the exhaust port 22 flows and diffuses toward a large rear space, so that the heated air exhausted can be prevented from being taken in from the intake port 33.

In all of the embodiments described above, the body 30 of the cover 3 is provided with three surfaces having different separation distances from the primary face 20a of the case 20, that is, the first face 30a to the third face 30c, but configurations are not limited thereto. For example, the body portion 30 of the cover 3 may have two surfaces having different separation distances from the primary face 20a of the case 20. In this case, for example, the second face 30b and the third face 30c may be formed as one surface having the same separation distance from the primary face 20a of the case 20. The one surface may be provided with a plurality of the through holes 36, and a plurality of the bolt holes BH for fixing. The body 30 of the cover 3 may also have a configuration of four or more surfaces with different separation distances from the primary face 20a of the case 20. With this configuration, pressure loss can be also reduced.

In all of the embodiments described above, the width of the intake flow path 34 is greater than or equal to the width of the opening 21, but the width is not limited thereto. For example, the width of the intake flow path 34 may be less than the width of the opening 21. The upper end of the intake flow path 34 is located above the upper end of the opening 21, but is not limited thereto.

In all of the embodiments described above, the opening 21 is provided on the primary face 20a of the case 20, which is an opposite surface to the wheelhouse 5 and the bracket 4. The cover 3 faces the primary face 20a of the case 20, and forms the intake flow path 34 with the primary face 20a. In other words, the intake flow path 34 is located on an opposite side of the wheelhouse 5 and the bracket 4 across the case 20. However, the intake flow path 34 may be disposed between the case 20 and the wheelhouse 5 and/or the bracket 4. In this case, the intake port 33 is further away from the vent holes 71a of the side trim 71 than in all of the embodiments described above, but still allows unheated air in the vehicle interior to be taken into the intake area SE through the vent holes 71a of the side trim 71.

In the first embodiment, second embodiment, and the modification of the second embodiment, the intake port 33 opens in the downward direction from the assembly 9, but configurations are not limited thereto. As in the comparative embodiment, the intake port 33 may open in any of upward, forward, and rearward directions from the assembly 9, as long as the intake port 33 opens in a direction orthogonal to the thickness direction of the assembly 9, and in a direction different from the opening direction of the exhaust port 22.

In all of the embodiments described above, the exhaust port 22 is provided only on the rear face 20f of the case 20, but the exhaust port 22 is not limited thereto. The exhaust port 22 may be provided on one side or two or more sides of the top face 20c, the bottom face 20d, or the front face 20e of the case 20, as long as the sides are located in a direction perpendicular to the thickness direction of the case 20, and in a direction different from the opening direction of the intake port 33.

In the second embodiment, when the exhaust port 22 is provided at a location other than the rear face 20f of the case 20, the direction in which the duct 8 extends from the exhaust port 22 is not limited to the rearward direction. For example, when the exhaust port 22 is provided at any of the top face 20c, the bottom face 20d, and the front face 20e of the case 20, the duct 8 is arranged to extend in a direction corresponding to the opening direction of the exhaust port 22 instead of the rearward direction. When the exhaust port 22 is provided at two or more side (multiple directions) of the case 20, the duct 8 corresponding to each exhaust port 22 or at least one exhaust port 22 may be connected to extend the duct 8 to a position separated from the exhaust port 22 and the intake port 33. With this configuration, by providing the duct 8, the air exhausted from the exhaust port 22 can be exhausted to a space further away from the intake port 33 of the cover, and the heated air exhausted from the exhaust port 22 can be also prevented from being taken in from the intake port 33.

In all of the embodiments described above, the electronic unit 2 is an inverter for providing AC power to a user, and is arranged at a position accessible to the user in the luggage room LG. However, the electronic unit 2 is not limited to an inverter, and may be a unit provided with an electronic component 23 that generates heat and requires cooling. In this case, the electronic unit 2 need not be located in a user-accessible position.

In all of the above-described embodiments, the assembly 9 is fixed to the vehicle body panel P (the wheelhouse 5 and the floor panel 6) via the bracket 4, and the electronic unit 2 is fixed to the bracket 4 via the cover 3, but the assembly 9 is not limited thereto. For example, the assembly 9 may be fixed directly to the vehicle body panel P. Further, for example, the electronic unit 2 may be fixed directly to the bracket 4 without the cover 3. These configurations do not substantially change the configurations for achieving the effects in any of the embodiments described above. Therefore, with these configurations, the effects (1) to (10) according to the first embodiment, and the effects (1) to (4) according to the second embodiment and the modifications of the second embodiment as described above can be also achieved.

In all of the embodiments described above, the assembly 9 is attached to the wheelhouse 5, but the assembly 9 not limited thereto, and may be attached to a side panel other than the wheelhouse 5 having a space extending in at least one direction. Further, the assembly 9 is arranged in an orientation (vertical placement) in which one side surface in the thickness direction is arranged along the inner wall surface 5a of the wheelhouse 5 which is a side panel of the vehicle, but configurations are not limited thereto. For example, the assembly 9 may be arranged such that one side surface thereof in the thickness direction is arranged along a surface of the floor panel 6 of the vehicle (horizontal placement). Further, although the assembly 9 is provided in the luggage room LG of the vehicle, it is not limited thereto. For example, the assembly 9 may be arranged on a side panel or a floor panel having a space extending in at least one direction in the passenger compartment. These configurations do not substantially change the configurations for achieving the effects in any of the embodiments described above. Therefore, with these configurations, the effects (1) to (10) of the first embodiment and the effects (1) to (4) of the second embodiment and the modifications of the second embodiment as described above can be also achieved.

Although the details of the present invention are described in accordance with the embodiments, it should be obvious to those skilled in the art that the present invention is not limited to these descriptions, and that various modifications and improvements can be made.

### REFERENCE SIGNS LIST

1, 1A, 1B, 1C: cooling structure of electronic unit; 2: electronic unit; 20: case; 20a: primary face; 21: opening; 22: exhaust port; 23: electronic components; 25: blower fan; 26: harness terminal (harness connection); 27: harness connection port; 3: cover; 33: intake port; 34: intake flow path; 36: through-holes; 4: bracket; 5: wheelhouse (side panel); 71: side trim (interior trim); 71: vent hole; 8: duct; 9: assembly (electronic unit and cover); P: vehicle body panel (wheelhouse, floor panel, side panel); LG: luggage room; h1: first isolation distance; h2: second isolation distance

## Claims

1. A cooling structure of an electronic unit mounted on a vehicle, the cooling structure comprising:
the electronic unit including an electronic component, a blower fan configured to cool the electronic component, and a case housing the electronic component and the blower fan; and
a cover attached to the electronic unit, wherein
an assembly of the electronic unit and the cover is arranged in an orientation in which one side surface in a thickness direction of the assembly is arranged along a surface of a vehicle body panel of the vehicle,
the case includes:
an opening that opens in the thickness direction, the opening through which air is taken in from an outside of the case into an inside of the case by the blower fan; and
an exhaust port that opens in a first direction orthogonal to the thickness direction, the exhaust port through which air taken into the case from the opening is exhausted to the outside of the case by the blower fan, and
the cover:
is provided to face the opening;
includes an intake port that opens in a second direction orthogonal to the thickness direction and different from the first direction, for taking in air from the outside of the case and the cover; and
forms an intake flow path communicating the intake port with the opening between the case and the cover.

2. The cooling structure according to claim 1, wherein a first separation distance in the thickness direction between the cover and a part of a surface of the case with the opening in which the intake flow path is provided is greater than a second separation distance in the thickness direction between the cover and an end face of the surface of the case with the opening in which the intake flow path is not provided.

3. The cooling structure according to claim 1 or 2, wherein
the vehicle body panel is a side panel of a luggage room of the vehicle,
the first direction is at least one of a rearward direction, a forward direction, or an upward direction of the vehicle, and
the second direction is a downward direction of the vehicle.

4. The cooling structure according to claim 3, wherein the cover includes a through hole in the upward direction of the vehicle than the opening.

5. The cooling structure according to any one of claims 1 to 4, further comprising a duct connected to the exhaust port and having a flow path cross-sectional area greater than a flow path cross-sectional area of the intake flow path.

6. The cooling structure according to claim 5, wherein
the vehicle body panel is arranged in a luggage room of the vehicle,
the first direction is a rearward direction of the vehicle, and
the duct extends rearward of the vehicle body panel.

7. The cooling structure according to claim 6, wherein
the assembly is attached to the vehicle body panel via a bracket, and
a rear end of the case is located in a forward direction of the vehicle than a rear end of the bracket.

8. The cooling structure according to any one of claims 1 to 7, wherein
the vehicle body panel is a side panel of a luggage room of the vehicle,
the second direction is a downward direction of the vehicle, and
the cooling structure further comprises a harness connection port that opens in the second direction, the harness connection port through which a harness connection portion provided at a portion of the case in the downward direction of vehicle is accessible.

9. The cooling structure according to any one of claims 1 to 8, wherein
the vehicle body panel is a side panel of a luggage room of the vehicle, and
the cooling structure further comprises a side trim arranged on an opposite side of the assembly to the vehicle body panel to cover the assembly and having a ventilation hole in a vicinity of the intake port.

10. The cooling structure according to any one of claims 1 to 9, wherein the vehicle body panel is a wheelhouse of a luggage room of the vehicle.

11. The cooling structure according to any one of claims 1 to 10, wherein
the assembly is attached to the vehicle body panel via a bracket, and
the case and the bracket are separated from each other.
